# EUROPÄISCHE PATENTANMELDUNG

(11) **EP 1 300 929 A1**
(43) Veröffentlichungstag der Anmeldung: **09.04.2003**
(21) Anmeldenummer: 02019718.2
(22) Anmeldetag: 03.09.2002
(51) Int. Cl.: H02K 11/04, H02K 5/14, H02K 19/36, H01L 25/03, H01L 23/40, H05K 7/20

(54) **Gleichrichtereinrichtung**

(30) Priorität: 02.10.2001 DE 10148668
(71) Anmelder: ROBERT BOSCH GMBH, 70442 Stuttgart (DE)
(72) Erfinder: Wolf, Gert, 71563 Affalterbach (DE)

(57) **Zusammenfassung**

Es wird eine Gleichrichtereinrichtung, insbesondere für einen Drehstromgenerator von Kraftfahrzeugen, vorgeschlagen, die zumindest mit einer in einem Hauptkühlkörper (23) angeordneten Diode (26) ausgestattet ist. Die Gleichrichtereinrichtung (20) ist dadurch gekennzeichnet, dass ein Zusatzkühlkörper (41) mit zumindest einer Diode (26) wärmeleitend verbunden ist.

## Beschreibung

### Stand der Technik

Die Erfindung betrifft eine Gleichrichtereinrichtung nach der Gattung des unabhängigen Patentanspruches. Aus dem europäischen Patent EP 0 329 722 B1 ist eine Gleichrichteranordnung bekannt, die aus zwei Hauptkühlkörpern besteht, in die jeweils mehrere Dioden eingepresst sind, die zur Gleichrichtung eines Drehstroms dienen. Die Dioden werden auf zwei verschiedene Wege gekühlt. Einerseits werden die Dioden direkt gekühlt, bspw. durch Kühlluft, die direkt über einen Diodenboden hinwegströmt oder durch Kühlung eines Hauptkühlkörpers, der die Wärme von einer zylindrischen Seitenfläche der Diode aufgenommen hat. Bei dieser Ausführung ist nachteilig, dass bei höheren Verlustleistungen der Dioden die Kühlkörper nicht beliebig nach radial außen vergrößert werden können, da diese dann die radiale Baugröße des Drehstromgenerators vergrößern würden. In der Folge würde dies zu Einbauproblemen bei vorhandenen Applikationen führen.

### Vorteile der Erfindung

Die erfindungsgemäße Gleichrichtereinrichtung mit den Merkmalen des Hauptanspruches hat den Vorteil, dass die radiale Baugröße des Hauptkühlkörpers nicht vergrößert werden muss um zu einer weiteren, verbesserten Kühlung der Dioden zu gelangen.

Durch die in den Unteransprüchen aufgeführten Maßnahmen sind vorteilhafte Weiterbildungen der Gleichrichtereinrichtung nach dem Hauptanspruch möglich.

Ist der Zusatzkühlkörper einstückig mit der Diode verbunden, entfällt der Arbeitsaufwand, den Zusatzkühlkörper an der Diode zu befestigen bzw. am Hauptkühlkörper zu befestigen. Darüber hinaus ist der Wärmeübergang zum Zusatzkühlkörper ideal.

Hat die Diode einen Diodenboden und befestigt man den Zusatzkühlkörper daran - bspw. durch Löten oder Kleben - so ist es möglich, vor dem Einbringen der Dioden in den Hauptkühlkörper die Kühlfunktion zu testen, bevor ein weiterer Arbeitsschritt vorgenommen wird. Das nachträgliche Befestigen des Zusatzkühlkörpers am Diodenboden hat auch den Vorteil, dass je nach Einzellage der Diode und je nach einzelner Kühlsituation der Diode unterschiedliche Zusatzkühlkörper an der Diode bzw. den Dioden befestigt werden können, ohne die Vielfalt der Dioden zu erhöhen.

Eine weitere Möglichkeit den Zusatzkühlkörper an der Diode zu befestigen ist bspw. dadurch gegeben, dass der Zusatzkühlkörper auf den zylindrischen Teil der Diode geschoben wird, wobei ein verbleibender zylindrischer Teil der Diode dazu genutzt wird, diese im Hauptkühlkörper zu befestigen. Hier entfällt der aufwendige und prozessunsichere Löt- bzw. Klebvorgang.

Um einen darüber hinaus verbesserten Wärmeübergang zwischen Dioden und Zusatzkühlkörper zu erreichen, ist es von Vorteil, den zunächst aufgeschobenen Kühlkörper mit dem Diodenboden zusätzlich bspw. zu verlöten.

Eine günstige Möglichkeit vorhandene Fertigungslinien für Gleichrichtereinrichtungen weitgehend unverändert zu lassen besteht darin, dass der Zusatzkühlkörper am Hauptkühlkörper befestigt ist und darüber hinaus mit dem zylindrischen Körper der Diode wärmeleitend verbunden ist. Auf diese Art und Weise ist es möglich, Gleichrichtereinrichtungen die keinen Zusatzkühlkörper benötigen, vorab aus der Fertigungslinie zu entfernen. Die Fertigungslinie wird demzufolge lediglich um die Station erweitert, in der die Zusatzkühlkörper am Hauptkühlkörper befestigt werden.

Eine vorteilhafte Ausgestaltung des Zusatzkühlkörpers besteht darin, diesen mit einem Plattenbereich zu versehen, der mit dem zylindrischen Körper der Diode zur Wärmeübertragung verbunden ist und andererseits den Plattenbereich mit einem Haltebereich zu verbinden, der den Zusatzkühlkörper mit dem Hauptkühlkörper verbindet. Vorteilhafte Verbindungsmechanismen sind z.B. Schraubverbindungen, die eine besonders schüttelfeste Verbindung ergeben oder Schnappverbindungen, die besonders schnell durchzuführende Verbindungen darstellen.

Schließt sich an den Plattenbereich ein Kühlflächenbereich an, der vom Hauptkühlkörper beabstandet ist, wird die effektive Kühloberfläche vergrößert, indem bspw. zwischen Hauptkühlkörper und Kühlflächenbereich ein weiterer Kühlmittelstrom zur Kühlung der Dioden dienen kann.

Weist der Kühlflächenbereich gleichzeitig eine allgemeine Wellenform auf, so erhält man ein besonders günstiges Verhältnis zwischen wärmeabgebender Kühloberfläche und geringem, sich von dem Hauptkühlkörper erstreckenden Bauraum. Vorteilhafte allgemeine Wellenformen sind z.B. rechteckförmig oder trapezförmig, die günstig bspw. durch Spritzgießen oder Tiefziehen herstellbar sind.

Damit der Zusatzkühlkörper quer zu seiner Erstreckung senkrecht vom Hauptkühlkörper aus keinen allzu großen Strömungswiderstand aufweist, hat der Zusatzkühlkörper zur Verringerung des Strömungswiderstandes Öffnungen. Günstige Öffnungen sind bspw. dadurch gegeben, dass der Zusatzkühlkörper gelocht oder geschlitzt ist und dadurch den Kühlmitteldurchtritt ermöglicht.

Weist der Zusatzkühlkörper eine Rippenstruktur auf, so wird dadurch die Wärmeabfuhr zusätzlich verbessert.

### Zeichnungen

In den Zeichnungen sind Ausführungsbeispiele einer erfindungsgemäßen Gleichrichtereinrichtung dargestellt. Es zeigen:
Figur 1A zeigt die Seitenansicht eines Ausschnittes der Gleichrichtereinrichtung mit einer Diode mit einstückig angeformtem Zusatzkühlkörper, Figur 1B zeigt die Draufsicht dazu,
Figur 2 einen auf dem Diodenboden einer Diode befestigten Zusatzkühlkörper,
Figur 3A und 3B je einen am zylindrischen Umfang der Diode befestigten Zusatzkühlkörper,
Figur 4A, 4B und 4C einen am Hauptkühlkörper befestigten Zusatzkühlkörper, der mit einem Plattenbereich auf dem Diodenboden anliegt,
Figur 5A und 5B zwei verschiedene Befestigungsmöglichkeiten für einen am Hauptkühlkörper befestigten Zusatzkühlkörper,
Figur 6A, 6B und 6C zeigen zwei Ausführungsbeispiele für Zusatzkühlkörper mit verringertem Strömungswiderstand,
Figur 7 zeigt ein Ausführungsbeispiel eines Zusatzkühlkörpers, um eine Vorspannung zwischen dem Plattenbereich und dem Diodenboden zu erreichen,
Figur 8 zeigt eine spezielle Geometrie für den Plattenbereich eines Zusatzkühlkörpers,
Figur 9 zeigt ein weiteres Ausführungsbeispiel eines Zusatzkühlkörpers,
Figur 10 zeigt eine Gleichrichtereinrichtung mit einem gemeinsamen Zusatzkühlkörper für mehrere Dioden,
Figur 11 zeigt die Gleichrichtereinrichtung mit Dioden nach Figur 1A bzw. 1B.

### Beschreibung des Ausführungsbeispieles

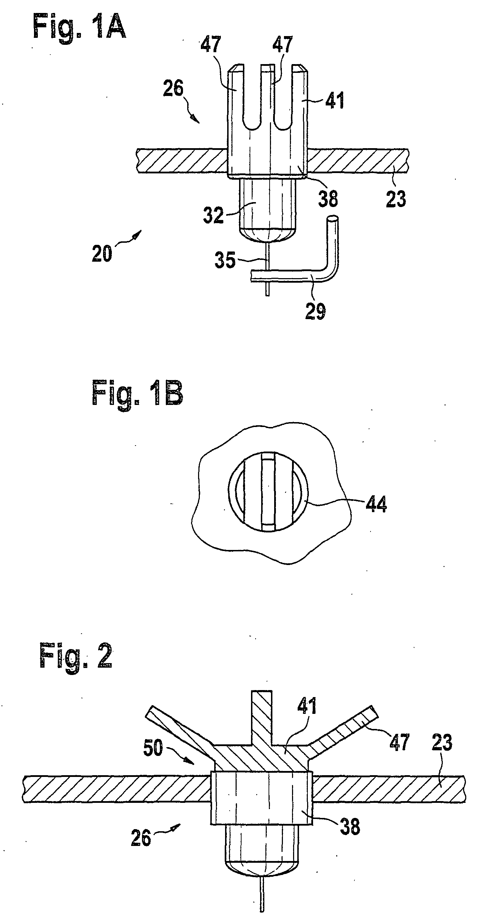

In Figur 1A ist ausschnittweise eine Gleichrichtereinrichtung 20 dargestellt. Die Gleichrichtereinrichtung 20 umfasst zumindest einen Hauptkühlkörper 23, in den eine Diode 26 eingesetzt ist. Die Diode 26 ist über Verschaltungselemente 29 mit anderen elektrische Bauteilen kontaktiert. Die Diode selbst besteht einerseits aus dem Chipabschnitt 32, in dem das eigentliche Halbleiterelement untergebracht ist. Der Chipabschnitt 32 ist einerseits mit einem Diodenkopfdraht 35 verbunden und andererseits mit einem Diodensockel 38, der zur Befestigung der Diode 26 im Hauptkühlkörper 23 dient. Mit der Diode 26 bzw. dem Diodensockel 38 ist ein Zusatzkühlkörper 41 wärmeleitend verbunden. Im dargestellten Ausführungsbeispiel ist der Zusatzkühlkörper 41 mit der Diode 26 einstückig verbunden. Wie aus Figur 1B hervorgeht, ist die Diode 26 im Wesentlichen zylindrisch ausgebildet. Damit die Diode 26 bspw. mit ihrem Zusatzkühlkörper 41 in eine Öffnung 44 des Hauptkühlkörpers 23 eingesetzt werden kann, ist der Zusatzkühlkörper 41 an seinem vom Diodenkopfdraht 35 abgewandten Ende angefaßt. Der Zusatzkühlkörper 41 weist an seinem vom Diodenkopfdraht 35 abgewandten Ende einzelne Rippen.47 auf, die zur verbesserten Wärmeabgabe dienen. Die verbesserte Wärmeabgabe wird durch die vergrößerte Oberfläche erreicht.

In Figur 2 ist ein weiteres Ausführungsbeispiel einer Diode 26 mit einem Zusatzkühlkörper 41 dargestellt. In der dargestellten Variante ist der Zusatzkühlkörper 41 am Diodenboden 50 befestigt. Der Diodenboden 50 ist der Oberflächenabschnitt der Diode 26, der nahezu planparallel bzw. plan mit dem mit einer Oberfläche des Hauptkühlkörpers 23 verläuft. Der Zusatzkühlkörper 41 ist bspw. am Diodenboden 50 angelötet.

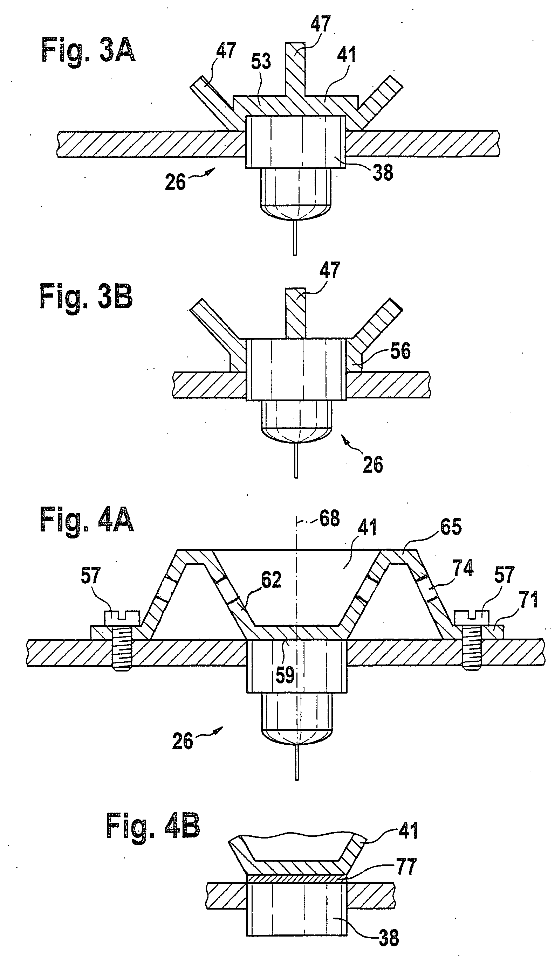

In Figur 3A ist ein weiteres Ausführungsbeispiel dargestellt. Die Diode 26 steht dabei mit ihrem Diodensockel 38 über die Oberfläche des Hauptkühlkörpers 23 über. Die Diode 26 ist im Wesentlichen zylindrisch ausgebildet, so dass ein zylindrischer Abschnitt der Diode 26 über den Hauptkühlkörper 23 steht. An diesem überstehenden Bereich des Diodensockels 38 ist der Zusatzkühlkörper 41 befestigt. Die Befestigung des Zusatzkühlkörpers 41 ist im Beispiel Figur 3A durch Festpressen des Zusatzkühlkörpers 41 am überstehenden Teil des Diodensockels 38 verwirklicht. Alternativ kann auch hier der Zusatzkühlkörper 41 am Diodensockel 38 festgelötet sein. Im Ausführungsbeispiel nach Figur 3a weist der Zusatzkühlkörper 41 einerseits einen Topfbereich 53 auf, an dessen von der Diode 26 abgewandten Oberfläche Rippen 47 angeformt sind. In Figur 3B ist eine Variante des Ausführungsbeispieles aus Figur 3A dargestellt. Der in Figur 3A vorgesehene Topfbereich 53 ist hierbei durch einen Ringbereich 56 ersetzt. An den Ringbereich 56 schließen sich die Rippen 47 an.

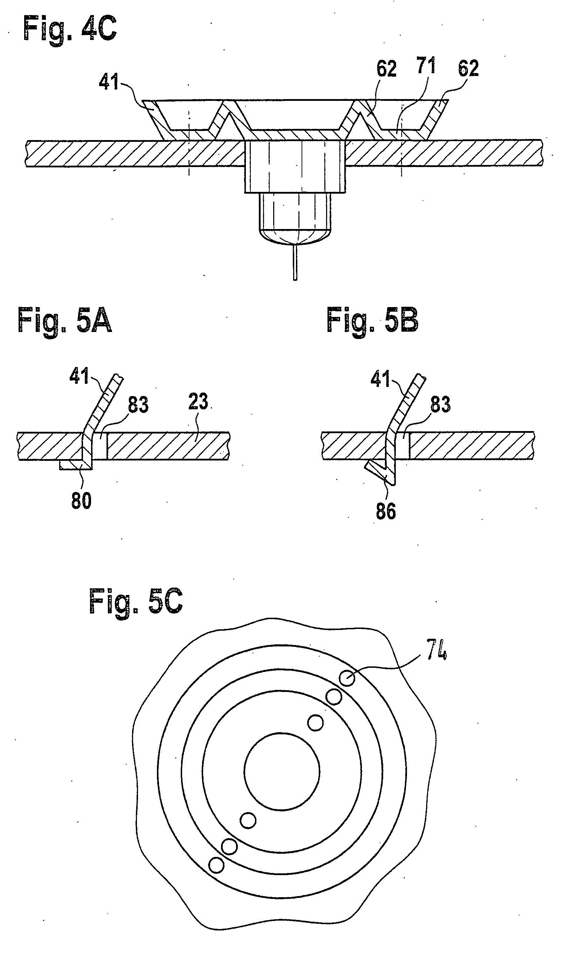

Das Ausführungsbeispiel nach Figur 4A zeigt einen Zusatzkühlkörper 41, der über Schrauben 57 als Verbindungselemente mit dem Hauptkühlkörper 23 verbunden bzw. an diesem befestigt ist. Im gezeigten Ausführungsbeispiel liegt der Zusatzkühlkörper 41 mit einem Kontaktbereich 59 am Diodenboden 50 wärmeleitend an und ist damit wärmeleitend mit diesem verbunden. Der Zusatzkühlkörper 41 ist insgesamt dabei wie folgt ausgebildet: Vom zentralen Kontaktbereich 59 ausgehend erstreckt sich von dessen Rand ausgehend ein vom Hauptkühlkörper 23 wegweisender Kühlflächenbereich 62, der in diesem Beispiel zunächst kegelmantelförmig ist. Der Kühlflächenbereich 62 weist einen ringförmigen Bereich 65 auf, von dem ausgehend und im Bezug zu einer Achse 68 der Diode 26 sich nach radial außen ein weiterer, kegelförmiger Bereich des Kühlflächenbereiches 62 anschließt, der zum Hauptkühlkörper 23 zurückgeführt ist. An diesen weiteren; kegelförmigen Kühlflächenbereich schließt sich schließlich ein Haltebereich 71 an, der zur Befestigung des Zusatzkühlkörpers 41 am Hauptkühlkörper 23 dient. Der Kühlflächenbereich 62 weist folglich eine allgemeine Wellenform auf und ist darüber hinaus rotationssymmetrisch aufgebaut. Der Zusatzkühlkörper 41 weist in seinem Kühlflächenbereich 62 Öffnungen 74 auf, die bspw. dazu dienen einerseits die Kühloberfläche zu vergrößern und andererseits den Strömungswiderstand des Zusatzkühlkörpers 41 zu verringern. Üblicherweise sind die Oberflächen von Kühlkörpern angeströmt bzw. überströmt, so dass Zusatzkühlkörper 41, die über die Oberfläche des Hauptkühlkörpers 23 hinausstehen, einen Strömungswiderstand für Kühlluft darstellen. Durch Öffnungen 74 wird der Strömungswiderstand verringert. In Figur 4B ist dargestellt, dass der Zusatzkühlkörper 41 - wie er aus Figur 1 bekannt ist - zusätzlich am Diodenboden 50 angelötet sein kann, Lötstelle 77. In Figur 4C ist ein ähnlicher Zusatzkühlkörper 41 dargestellt, wie er bereits aus Figur 4a bekannt ist. Im Unterschied dazu ist jedoch die Bauhöhe des Zusatzkühlkörpers 41 verringert und die Breite des Zusatzkühlkörpers vergrößert, indem am Außenrand des Haltebereiches 71 ein weiterer kegelstumpfmantelartiger Rand angeordnet wurde, um den Kühlflächenbereich 62 zu vergrößern.

Alternativ zur Befestigung mittels Schrauben oder bspw. Nieten ist es auch möglich, den Zusatzkühlkörper 41 bspw. mittels umgebogener Laschen 80 am Zusatzkühlkörper 41 zu befestigen. Dazu werden die Zusatzkühlkörper 41 mit den zunächst in etwa geradlinigen Laschen 80 durch Öffnungen 83 des Hauptkühlkörpers 23 durchgesteckt und anschließend umgebogen, damit die abgebogenen Laschen 80 einen Hinterschnitt im Halteloch 83 bilden. Eine weitere alternative Verbindung des Zusatzkühlkörpers 41 mit dem Hauptkühlkörper 23 besteht darin, mittels einer Schnappverbindung 86, die in Haltelöcher 83 eingreift, eine Verbindung herzustellen.

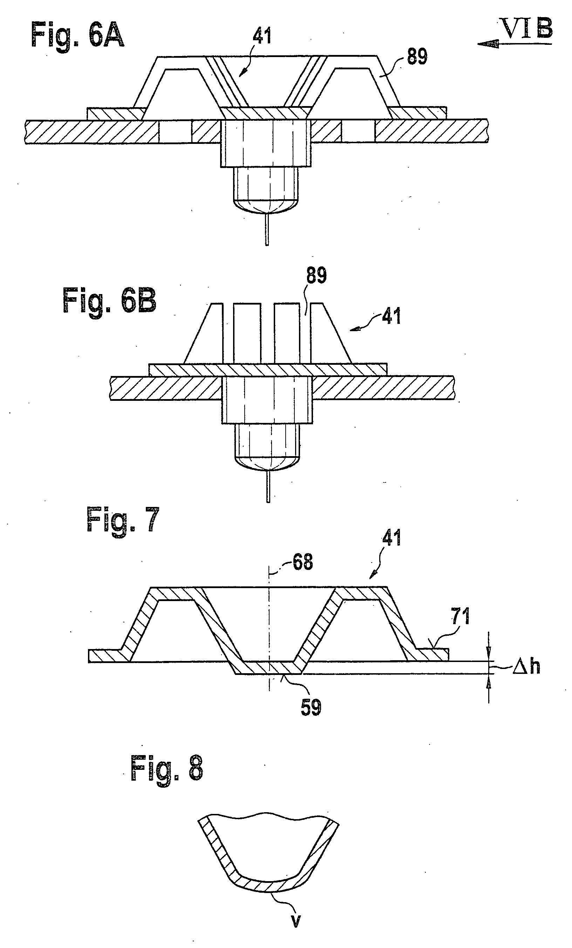

Figur 6A zeigt eine Variante des Zusatzkühlkörpers 41 aus Figur 4A. Um den Strömungswiderstand des Zusatzkühlkörpers 41 zu verringern, sind die Öffnungen 74 als Schlitze 89 ausgebildet. Der Pfeil in Figur 6A gibt nicht nur die Seitenansicht der Figur 6B an, sondern auch gleichzeitig die bevorzugte Strömungsrichtung der Kühlluft.

Alternativ zur Verringerung des Strömungswiderstandes mittels der Schlitze 89 ist - wie bereits zu Figur 4A angesprochen - auch eine Strömungsverringerung mittels einfacher Löcher bzw. Öffnungen 74 möglich. Ordnet man, wie in Figur 6C dargestellt, die Öffnungen 74 in Richtung der einströmenden Kühlluft an, so erreicht man gezielt eine Strömungswiderstandsverringerung in eine Richtung, bspw. der Strömungsrichtung.

Der Wärmeübergang zwischen dem Diodenboden 50 und dem Kontaktbereich 59 soll besonders gut sein. So ist als weiteres Ausführungsbeispiel vorgesehen, den Zusatzkühlkörper 41 bzw. dessen Haltebereich 71 gegenüber dem Kontaktbereich 59 um einen bestimmten Höhenunterschied Δₕ abzuheben. Dies führt dazu, dass bei bündigem Anliegen des Haltebereiches 71 am Hauptkühlkörper 23 im Bereich des Kontaktbereiches 59 auf den Diodenboden 50 eine Druckspannung wirkt. Der Wärmeübergang ist dadurch verbessert.

Je nach Größe der Druckspannung zwischen Diodenboden 50 und Kontaktbereich 59 ist es erforderlich, durch gezielte, ballige Ausbildung des Kontaktbereiches 59 eine weitestgehend konstante Druckspannung zwischen Kontaktbereich 59 und Diodenboden 50 herzustellen.

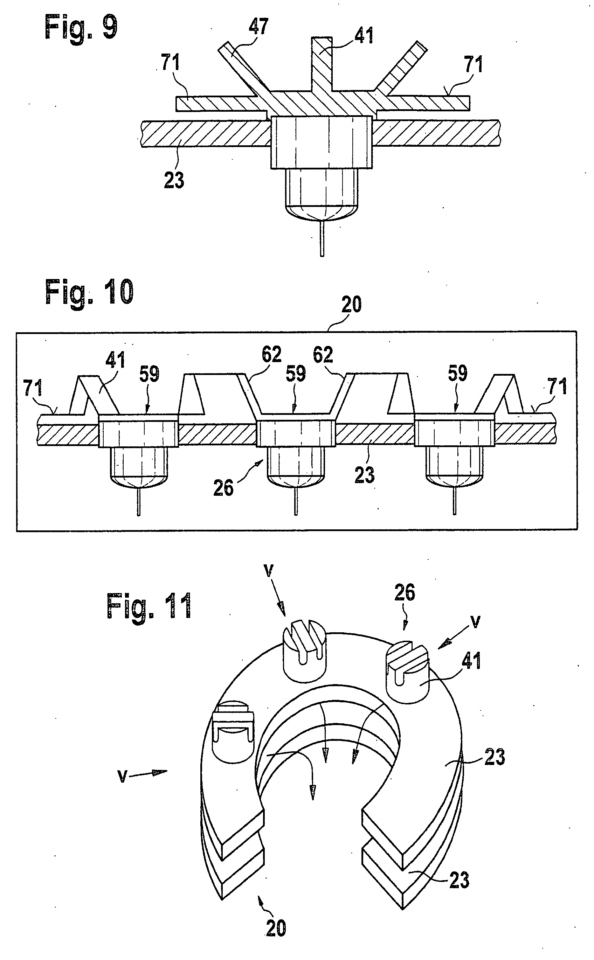

Ein weiteres Ausführungsbeispiel für einen Zusatzkühlkörper 41 ist in Figur 9 dargestellt. An den Kontaktbereich 59 schließen sich rechts und links je ein Haltebereich 71 an, über den der Zusatzkühlkörper 41 am Hauptkühlkörper 23 befestigt ist. Vom Kontaktbereich 59 aus erstrecken sich einzelne Rippen 47. Der Zusatzkühlkörper 41 kann in diesem Beispiel sowohl als Strangussteil mit konstantem Querschnitt ausgeführt sein, als auch als bspw. rotationssymmetrisches Teil mit dem entsprechenden, in Figur 9 dargestellten, Querschnitt.

Die in Figur 10 dargestellte Gleichrichtereinrichtung 20 weist mehrere Dioden 26 auf, die im Hauptkühlkörper 23 eingepresst bzw. angeordnet sind. Alle - in diesem Beispiel drei - Dioden 26 liegen mit ihrem Diodenboden 50 im Wesentlichen in einer gleichen Ebene mit einer Oberfläche des Hauptkühlkörpers 23. Der Zusatzkühlkörper 41 ist im Beispiel nicht ein einzelner Zusatzkühlkörper 41 für je eine einzelne Diode 26, sondern insgesamt bspw. ein in Figur 10 dargestelltes, im Wesentlichen ringförmiges Blech mit einer allgemeinen Wellenform. Wesentliche Teile des Kühlflächenbereiches 62 sind von der Oberfläche des Hauptkühlkörpers 23 beabstandet und wechseln mit Kontaktbereichen 59 ab. Die entsprechend beabstandeten Kühlflächenbereiche 62 sind nach radial innen gerichtet und ermöglichen so eine gerichtete bzw. geleitete Kühlluftströmung nach radial innen.

In Figur 11 ist eine Gleichrichtereinrichtung 20 mit zwei Hauptkühlkörpern 23 dargestellt. Die beiden Hauptkühlkörper 23 liegen hier bspw. übereinander und sind im Wesentlichen hufeisenförmig bzw. kreisringsegmentförmig, da üblicherweise in dem ausgesparten Segment ein Bürstenhalter für einen Wechselstromgenerator bzw. Drehstromgenerator angeordnet ist. Die Aussparung ist nicht erforderlich, wenn die räumlichen Gegebenheiten dies zulassen. Die Gleichrichtereinrichtung 20 bzw. ein Hauptkühlkörper 23 trägt üblicherweise drei Dioden 26, wobei hier in diesem Fall lediglich die Zusatzkühlkörper 41 zu erkennen sind. Man erkennt deutlich, dass die Rippen 47 der Zusatzkühlkörper 41 insgesamt radial ausgerichtet sind, um die radiale Zufuhr des Kühlluftstromes v nicht unnötig zu behindern. Die radial eingesaugte Kühlluft strömt üblicherweise weiter nach axial innen in den Generator. Die Form der Dioden 26 ist nicht auf die zylindrische Form beschränkt.

## Patentansprüche

1. Gleichrichtereinrichtung, insbesondere eines Drehstromgenerators für Kraftfahrzeuge, mit zumindest einer in einem Hauptkühlkörper (23) angeordneten Diode (26), **dadurch gekennzeichnet, dass** ein Zusatzkühlkörper (41) mit zumindest einer Diode (26) wärmeleitend verbunden ist.

2. Gleichrichtereinrichtung nach Anspruch 1, **dadurch gekennzeichnet, dass** der Zusatzkühlkörper (41) einstückig mit der Diode (26) verbunden ist.

3. Gleichrichtereinrichtung nach Anspruch 1, **dadurch gekennzeichnet, dass** die Diode (26) einen Diodenboden (50) hat und der Zusatzkühlkörper (41) am Diodenboden (50) befestigt ist.

4. Gleichrichtereinrichtung nach Anspruch 1, **dadurch gekennzeichnet, dass** die Diode (26) einen Diodensockel (38) hat, der teilweise über den Hauptkühlkörper (23) übersteht und der Zusatzkühlkörper (41) am überstehenden Teil des Diodensockels (38) befestigt ist.

5. Gleichrichtereinrichtung nach Anspruch 1, **dadurch gekennzeichnet, dass** der Zusatzkühlkörper (41) am Hauptkühlkörper (23) befestigt ist und mit der Diode (26) wärmeleitend verbunden ist.

6. Gleichrichtereinrichtung nach Anspruch 5, **dadurch gekennzeichnet, dass** der Zusatzkühlkörper (41) mit einem Kontaktbereich (59) mit der Diode (26) verbunden ist und der Kontaktbereich (59) mit einem Haltebereich (71) des Zusatzkühlkörpers (41) verbunden ist, der zum Verbinden des Zusatzkühlkörpers (41) mit dem Hauptkühlkörper (23) dient.

7. Gleichrichtereinrichtung nach Anspruch 5 oder 6, **dadurch gekennzeichnet, dass** sich an den Kontaktbereich (59) ein Kühlflächenbereich (62) anschließt, der vom Hauptkühlkörper (23) beabstandet ist.

8. Gleichrichtereinrichtung nach Anspruch 7, **dadurch gekennzeichnet, dass** der Kühlflächenbereich (62) eine allgemeine Wellenform aufweist.

9. Gleichrichtereinrichtung nach einem der vorstehenden Ansprüche, **dadurch gekennzeichnet, dass** der Zusatzkühlkörper (41) Öffnungen (74) hat.

10. Gleichrichtereinrichtung nach einem der vorhergehenden Ansprüche, **dadurch gekennzeichnet, dass** der Zusatzkühlkörper (41) zumindest eine Rippenstruktur (47) aufweist.
